# EUROPEAN PATENT APPLICATION

(11) **EP 1 154 037 A1**
(43) Date of publication of application: **14.11.2001**
(21) Application number: 01304238.7
(22) Date of filing: 11.05.2001
(51) Int. Cl.: C23C 16/44, B08B 7/00

(54) **Methods for improving chemical vapor deposition processing**

(30) Priority: 12.05.2000 US 569551
(71) Applicant: Applied Materials, Inc., Santa Clara, California 95054 (US)
(72) Inventor: Robertson, Robert, Saratoga, CA 95070 (US); Kollrack, Mike, San Francisco, CA 94122 (US); Lee, Angela, San Jose, CA 95129 (US); Takehara, Takako, Hayward, CA 94541 (US); Feng, Jeff, Saratoga, CA 95070 (US); Shang, Quanyuan, Saratoga, CA 95070 (US); Law, Kam, Union City, CA 94587 (US)
(74) Representative: Allard, Susan Joyce

(57) **Abstract**

A multi-step process is used to condition a chemical vapor deposition chamber after cleaning and between successive depositions by removing fluorine residues from the chamber with a hydrogen plasma, and subsequently depositing a solid compound in the chamber to encapsulate any particulates remaining in the chamber.

## Description

This invention relates broadly to chemical vapor deposition (CVD) processing. More particularly, this invention relates to minimizing contaminates by 1) reacting contaminates with reactive gases and clearing the reaction products from the chamber, followed by 2) adding an inert gas which coats any remaining contaminates to ensure they do not subsequently contaminate substrates in a subsequent chemical vapor deposition process.

CVD is widely used in the semiconductor industry to deposit films of various kinds, such as intrinsic and doped amorphous silicon, silicon oxide, silicon nitride, silicon oxynitride and the like on a substrate. Modern semiconductor CVD processing is generally done in a vacuum chamber by heating precursor gases which dissociate and react to form the desired film. In order to deposit films at low temperatures and relatively high deposition rates, a plasma can be formed from the precursor gases in the chamber during the deposition. Such processes are known as plasma enhanced chemical vapor deposition processes, or PECVD.

State of the art CVD chambers are made of aluminum and include a support for the substrate to be processed, and a port for entry of the required precursor gases. When a plasma is used, the gas inlet and/or the substrate support will be connected to a source of power, such as an RF power source. A vacuum pump is also connected to the chamber to control the pressure in the chamber and to remove the various gases and particulates generated during the deposition.

As semiconductor devices on a substrate become smaller and are made closer together, particulates in the chamber must be kept to a minimum. Particulates are formed because during the deposition process, the film being deposited deposits not only on the substrate, but also deposits on the walls and various fixtures, e.g., shields, substrate support and the like in the chamber. During subsequent depositions, the film on the walls etc, can crack or peel, causing contaminant particles to fall onto the substrate. This causes problems and damage to particular devices on the substrate. When individual devices or die are cut from a silicon wafer, for example, damaged devices, such as transistors, can be discarded.

Similarly, when large glass substrates are processed to form thin film transistors for use as computer screens and the like, up to one million transistors are formed on a single substrate. The presence of contaminates in the processing chamber is also serious in this case, since the computer screen and the like will not be operative if damaged by particulates.

Thus the CVD chamber must be periodically cleaned to remove particulates between depositions. Cleaning is generally done by passing an etch gas, particularly a fluorine-containing gas such as nitrogen trifluoride, into the chamber. A plasma is then initiated from the fluorine-containing gas which reacts with coatings from prior depositions on the chamber walls and fixtures, i.e., coatings of amorphous silicon, silicon oxide, silicon nitride and the like, and any particulates in the chamber, to form gaseous fluorine-containing products that can be pumped away through the chamber exhaust system. This is generally followed by a nitrogen purge.

However, it has been found that fluorine residues remain in the chamber after this cleaning step, and, more importantly, particulates are not totally removed from the chamber. The fluorine residues can adversely affect the film quality of subsequently deposited films, particularly of amorphous silicon over silicon nitride films, and the threshold voltage of devices made therefrom is shifted. The presence of particulates can damage devices on the substrate.

Thus a process was sought that could condition a CVD chamber between deposition steps using a fluorine-containing gas, and then remove any fluorine residues remaining in the chamber, and at the same time ensure that particulates remaining in the chamber do not fall onto the substrate.

We have found a multi-step conditioning process for a CVD chamber after cleaning of the chamber of unwanted deposits using a fluorine-containing gas, that removes the fluorine residues from the chamber and reduces the number of particles in the chamber that can fall upon a subsequently processed substrate.

In a preceding cleaning step, fluorine is passed into the chamber where it reacts with unwanted deposits and particles. In a first conditioning step of the invention, a plasma is formed in the chamber from hydrogen, which reacts with any fluorine residues remaining in the chamber. These are swept away. In a second conditioning step, a plasma is formed from a deposition gas mixture, forming a layer of a solid compound on the walls and fixtures of the chamber, effectively encapsulating any particulates remaining on the internal surfaces of the chamber.

The deposition gas mixture can be silane and optionally added co-reactants, forming a solid silicon compound such as silicon oxide or silicon nitride in the chamber. Alternatively, the deposition gas mixture can be tetraethoxysilane (TEOS) and oxygen, forming a silicon oxide compound. In general, the deposition gas mixture used in the conditioning step uses some of the same gases that are used for depositing the film on a substrate.
The following drawings are provided by way of example:

Fig. 1 is a cross sectional plan view of a PECVD chamber useful for depositing thin films on a large area glass substrate.

Fig. 2 is a flow chart setting forth the steps of the preferred process of the invention.

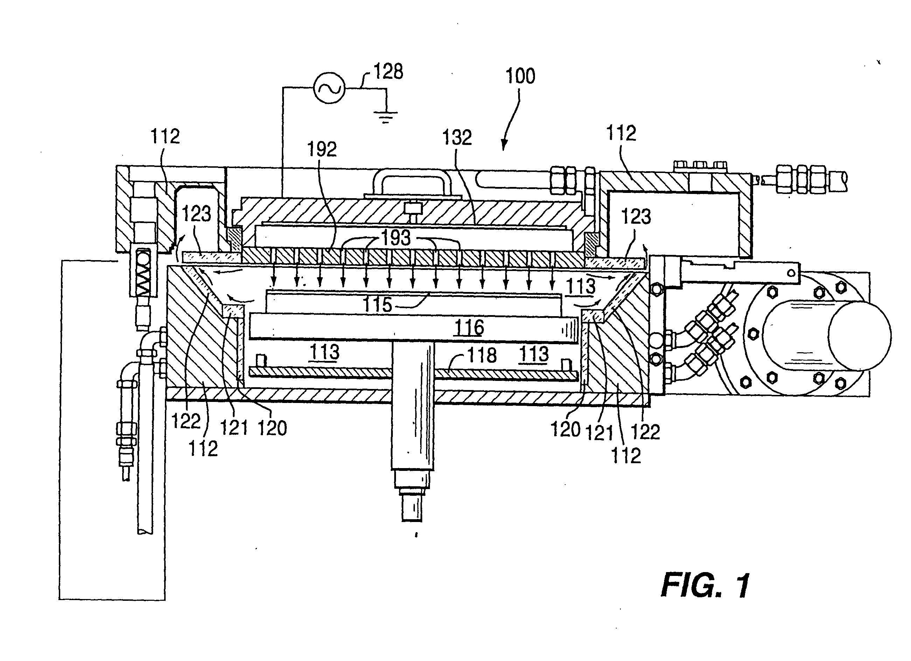

US Patent 5,366,585 to Robertson et al, incorporated herein by reference, discloses a PECVD chamber suitable for processing large area glass plates. Referring now to Figure 1, a vacuum chamber 113 surrounded by a reactor housing 112 includes a hinged-lid. A gas manifold 132 is situate over and parallel to a susceptor 116 upon which the substrate is mounted during processing. The gas manifold 132 includes a face plate 192 having a plurality of orifices 193 therein for supplying process and purge gases. An RF power supply 128 creates a plasma from the supplied gases.

A set of ceramic liners 120, 121 and 122 adjacent to the housing 112 insulate the metal walls of the housing 112 so that no arcing occurs between the housing 112 and the susceptor 116 during plasma processing. These ceramic liners 120, 121 and 122 also can withstand fluorine-containing etch cleaning gases. A ceramic annulus 123 is also attached to the face plate 192 to provide electrical insulation for the face plate 192. These ceramic parts also repel plasma and thus aid in confining the processing plasma close to the substrate and aid in reducing the amount of deposit build-up on the walls of the housing 112.

After the last substrate on which a layer is to be deposited is removed from the chamber, a standard fluorine containing gas clean is first carried out in the chamber in a conventional manner. A flow of 800 sccm of nitrogen trifluoride is established with the gas inlet valve wideopen, producing a pressure of 200 millitorr in the chamber, with a susceptor-gas manifold spacing of 1600 mils. An RF power of 1600 Watts is applied to the gas manifold to produce a plasma. The cleaning plasma is continued for a period of about one minute for each 2000 angstroms of amorphous silicon film that had been previously deposited in the chamber. Cleaning plasma is additionally continued for about one minute for each 4000 angstroms of silicon nitride film previously deposited on the substrate within the chamber.

The following two step conditioning process is used to remove fluorine residues remaining after the above CVD chamber clean step and to deposit a thin, inactive solid compound film on the walls and fixtures in the chamber to encapsulate particles.

As an example of the present process, in a first conditioning step, a hydrogen plasma was formed in the chamber by passing 1200 sccm of hydrogen into the chamber for 30 seconds, creating a plasma using 300 Watts of power. The hydrogen plasma reacted with fluorine present in the chamber, forming HF which was readily removable via the chamber exhaust system. The chamber was maintained at the temperature to be used for subsequent deposition, and a pressure of 1.2 Torr. The spacing between the substrate support and the gas manifold was 1462 mils.

In a second conditioning step, a thin film of silicon nitride was deposited under the same spacing, temperature and pressure conditions, but increasing the power to 800 Watts and changing the gases. The silicon nitride film was deposited by passing 100 sccm of silane, 500 sccm of ammonia and 3500 sccm of nitrogen into the chamber for an additional 30 seconds.

The total time needed to condition the chamber for subsequent deposition processing is thus only about one minute. The thin silicon nitride film coats the walls and fixtures of the chamber, thereby encapsulating and sealing any remaining particles in the chamber after the cleaning step so they cannot fall onto the substrate to be processed. The deposited silicon nitride layer also reduces outgassing of wall materials and also further reduces any remaining fluorine-containing materials from the chamber.

The above two-step conditioning process is employed with standard cleaning processes, including clean stabilization, plasma clean with a fluorine-containing gas, followed by a nitrogen purge. After the hydrogen plasma treatment and the silicon compound deposition of the present conditioning process, the chamber may be purged with nitrogen.

The above process is preferred because it both removes fluorine-containing residues and reduces the number of particles in the chamber with a minimum reduction in system throughput. Alternative single-step conditioning processes using the same amount of processing time have been tried but are not as effective as the present process. A single 60 second silicon nitride deposition process is effective for reducing particles, but is less effective for reducing fluorine residues. It also creates a thicker wall deposit which must be etched away in a subsequent cleaning step. A single 50 second step of forming a hydrogen plasma is effective for reducing fluorine residues, but is not effective for reducing particles. A single 60 second step of amorphous silicon deposition, formed by adding silane to the hydrogen plasma process, is effective for reducing fluorine residues because of the high hydrogen atom production. However, the particle reduction is not as effective as the silicon nitride deposition. Also, again, the amorphous silicon deposition would need to be removed in a subsequent cleaning step.

Alternative two-step conditioning processes using the same amount of processing time are not as effective either. A thirty second amorphous silicon deposition plus a 30 second silicon nitride deposition would be effective for reducing fluorine residues and particles. However, the added amorphous silicon wall deposit would need to be removed in a subsequent cleaning step. The above multi-step cleaning and conditioning process is employed with conventional stabilization of the reaction chamber between cleaning steps, and a nitrogen purge can be used after the fluorine cleaning step and after the silicon nitride deposition step, in preparation for subsequent CVD processing.

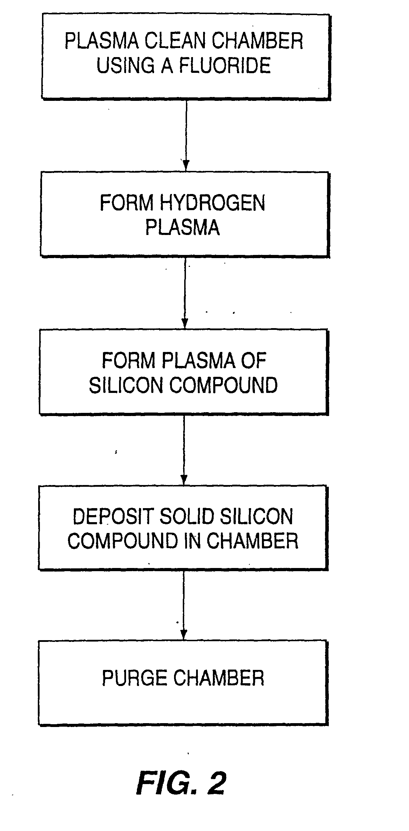

Fig. 2 is a flow chart illustrating the preferred sequence of steps of the present CVD chamber cleaning and conditioning processes. The plasma CVD chamber is first cleaned with a fluorine-containing gas, a hydrogen plasma is formed in the chamber to remove fluorine residues, a plasma of a silicon compound precursor gases is formed, a solid silicon compound is deposited on the interior of the chamber, and the chamber finally is purged with an inert gas prior to inserting a substrate into the chamber upon which a material is to be deposited.

Although the present process has been described in terms of particular embodiments, it will be apparent to one skilled in the art that various changes in the gases, reaction conditions, and the like can be made and are meant to be included herein.

Further, although a particular CVD chamber has been described herein, many CVD chambers are available commercially arid can be cleaned and conditioned in accordance with the present process. The invention is to be limited only by the scope of the appended claims.

## Claims

1. A method of minimizing contamination in a chemical vapor deposition (CVD) chamber following cleaning of the chamber, the method comprising:
a) forming a hydrogen plasma in a chemical deposition chamber, wherein said plasma reacts with molecules present to form a reaction product;
b) removing the reaction product from the chamber; and
c) depositing a thin, inactive solid compound film on an interior surface of the CVD chamber,
wherein the solid compound film encapsulates particulates remaining in the chamber.

2. The method of claim 1, wherein the molecules present following removal of the reaction product are or comprise halogen residues.

3. The method of claim 2, wherein the halogen residues are or comprise fluorine residues.

4. The method of any one of claims 1 to 3, wherein the solid compound film is deposited using a gas which is or comprises a silane.

5. The method of claim 4, wherein a nitrogen-containing gas is added to the silane during deposition.

6. The method of claim 5, wherein said nitrogen-containing gas is or comprises ammonia.

7. The method of any one of claims 1 to 6, wherein the solid compound film is deposited using a gas which is or comprises tetraethoxysilane.

8. The method of any one of claims 1 to 7, wherein a hydrogen plasma is formed in the chamber by introduction of a hydrogen gas at about 300 Watts of power.

9. The method of any one of claims 1 to 8, wherein the inactive solid compound film is or comprises silicon nitride.

10. The method of claim 9, wherein the silicon nitride film is deposited at about 800 Watts.

11. A method of neutralizing contaminates in a chemical deposition vapor (CVD) processing chamber, said method comprising the steps of:
a) introducing a halogen-containing gas to a CVD processing chamber, wherein said halogen-containing gas reacts with contaminates on a surface of the chamber to produce a reaction product;
b) removing the reaction product from the CVD processing chamber;
c) introducing hydrogen into the CVD processing chamber to form a hydrogen plasma, wherein the hydrogen plasma reacts with residue from the halogen-containing gas; and
d) introducing a deposition gas mixture into the chamber to deposit a layer of a solid compound on an interior surface of the CVD processing chamber,
wherein the halogen-containing gas and hydrogen plasma provide removal of chemical contaminates, and wherein the deposition of a solid compound encapsulates remaining contaminates on the interior surface of the CVD processing chamber.

12. The method of claim 11, wherein the halogen-containing gas is or comprises a fluorine-containing gas.

13. The method of claim 12, wherein said fluorine-containing gas is or comprises nitrogen trifluoride.

14. The method of any one of claims 11 to 13, wherein the hydrogen plasma is formed by passing about 1200 sccm of hydrogen into the CVD chamber for about 30 seconds.

15. The method of any one of claims 11 to 14, wherein the hydrogen plasma is formed using about 300 Watts of power at a pressure of about 1.2 Torr.

16. The method of any one of claims 11 to 15, wherein deposition gas mixture includes a silane, and wherein said silane forms a solid silicon compound layer on the interior surface of the CVD processing chamber.

17. The method of any one of claims 11 to 16, wherein said solid compound layer is or comprises a silicon oxide.

18. The method of any one of claims 11 to 17, wherein a nitrogen-containing gas is added to the deposition gas.

19. The method of any one of claims 11 to 16 and 18, wherein the solid compound layer is or comprises silicon nitride.

20. The method of claim 19, wherein the silicon nitride is formed from a gas mixture comprising about 100 sccm silane, about 500 sccm ammonia, and about 3500 sccm nitrogen.

21. The method of claim 19 or claim 20, wherein the silicon nitride is formed by exposing the chamber to the deposition gas for about 30 seconds.

22. The method of any one of claims 19 to 21, wherein the silicon nitride is deposited at about 800 watts.

23. The method of any one of claims 11 to 17, wherein the deposition gas is or comprises tetraethoxysilane, and wherein said silane forms a solid silicon oxide compound layer on the interior surface of the chamber.
